# EUROPÄISCHE PATENTSCHRIFT

(11) **EP 0 510 323 B1**
(45) Veröffentlichungstag und Bekanntmachung des Hinweises auf die Patenterteilung: **31.08.1994**
(21) Anmeldenummer: 92102723.1
(22) Anmeldetag: 19.02.1992
(51) Int. Cl.: B23K 1/005, H05K 13/04, H01L 21/60, H01L 21/68

(54) **Einrichtung zum Laserlöten**
Device for laser soldering
Dispositif de brasage au laser

(30) Priorität: 25.02.1991 DE 4105875
(43) Veröffentlichungstag der Anmeldung: 28.10.1992
(73) Patentinhaber: TEMIC TELEFUNKEN microelectronic GmbH, 74072 Heilbronn (DE)
(72) Erfinder: Möller, Werner, Dipl.-Chem. Dr., W-7900 Ulm (DE); Knödler, Dieter, Dipl.-Ing., W-7339 Eschenbach (DE)
(74) Vertreter: Maute, Hans-Jürgen, Dipl.-Ing.

(56) Entgegenhaltungen:
- EP-A- 0 326 020
- PATENT ABSTRACTS OF JAPAN vol. 14, no. 546 (E-1008)4. Dezember 1990 & JP-A-2 232 999 (MATSUSHITA ELECTRIC IND CO) 14 September 1990
- IBM TECHNICAL DISCLOSURE BULLETIN. Bd. 31, Nr. 6, November 1988, NEW YORK USSeiten 385 - 389; 'LASER MICROWELDING OF TAPE AUTOMATED BONDING COMPONENTS FORSURFACE MOUNTED TECHNOLOGIES'

## Beschreibung

Die Erfindung bezieht sich auf eine Einrichtung zum Laserlöten von Feinkontakten vorbeloteter mikroelektronischer Bauelemente gemäß dem Oberbegriff des Anspruches 1.

Eine solche Einrichtung ist aus der JP-A-2232999 bekannt.

Einrichtungen zur kurzzeitigen Fixierung von leicht verformbaren und mit einem Laser zu verlötenden Mikroteilen, die weder mittels Flußmittel noch mit Lotpaste miteinander verklebt werden, sondern lediglich vorbelotet sind, sind u.a. durch die Anmelderin bekannt geworden. Zum Stand der Technik werden die DE-OS 36 06 764 A1, die DE-PS 37 01 013 C2 sowie die DE 39 39 812.9 genannt, die einen Laserkopf mit einer Haltevorrichtung für Mikrokontakte beschreibt. Mit diesen Eirichtungen des Standes der Technik können vorverzinnte Mikroelektronik-Bauelemente mit sehr dünnen, zahlreichen, parallelen Kontakten (sog. Leads) und geringen Abständen (fine pitch) nach dem rationellen TAB-Lötverfahren (Tape Automated Bonding) einwandfrei miteinander verbunden werden.

Der Nachteil dieser Einrichtungen ist Jedoch, daS der malteserkreuzartige Niederhalter bzw. die Haltevorrichtung eine für Mikro-Elektronikschaltungen zu große Fläche beansprucht und von den Bauelementgrößen sowie den Kontaktdimensionen abhängig bzw. spezifisch ist und bei einem Bauelementwechsel ausgetauscht werden muß. Wenn man nun in Betracht zieht, daS durch das Laserlöten von TAB-Kontakten der Vorteil gegeben ist, die Laserlöt-Koordinaten mit den Positionierdaten über ein Programm schnell ausgewechselt werden können und daher das Verfahren gegenüber den bisherigen des Stempellötens mit sehr spezifischen, eng in den Dimensionen tolerierten Thermoden-Werkzeugen sehr flexibel ohne lange Umrüstzeiten eingesetzt werden könnte, schränkt dieser Nachteil die Wirtschaftlichkeit des Verfahrens sehr erheblich ein.

Weitere Niederhalter sind aus den Druckschriften "IBM-Technical Disclosure Bulletin" und der EP-A-326 020 bekannt. Im einen Fall handelt es sich um fixierte Plattenelemente mit entsprechenden Aussparungen für die Positionierung der Leads etc. und im anderen Fall ist es ebenfalls ein Plattenelement mit Durchtrittsöffnung für den Laserstrahl. Für allseitige optimale Kontaktierung sind solche Plattenniederhalter nicht geeignet.

Der vorliegenden Erfindung liegt die Aufgabe zugrunde, eine Einrichtung der eingangs genannten Art zu schaffen, die in einfacher und zuverlässiger Weise den vorgenanten Nachteil beseitigt und einen exakt positionierbaren Niederhalter für Mikrokontakte schafft, der schnell und hoch-genau gegebenen Kontakt- bzw. Bauelement-Dimensionen auf engstem Raum angepaßt werden kann.

Diese Aufgabe wird durch die im Anspruch 1 aufgezeigten Maßnahmen gelöst. In den Unteransprüchen sind Maßnahmen zur Weiterbildung und Ausgestaltung angegeben und in der nachfolgenden Beschreibung sind Ausführungsbeispiele und Verfahrensmaßnahmen erläutert, wobei diese Erläuterungen durch die Figuren der Zeichnung ergänzt werden. Es zeigen:
- Fig. 1: ein perspektivisches Schemabild des ersten XY-Tisches mit Z-Achsenverstellungseinrichtung und Laser-Bestückungs- und Lötkopfes,
- Fig. 2: ein Ausführungsbeispiel eines Laser-Bestückungs- und Lötkopfes wie er durch die Anmelderin bekanntgeworden ist,
- Fig. 3a: einen Querschnitt durch ein Ausführungsbeispiel eines Niederhalters für die Kontaktbügel eines Mikrochips,
- Fig. 3b: einen weiteren Querschnitt eines anderen Ausführungsbeispieles eines Niederhalters für die Kontaktbügel von Mikrochips,
- Fig. 4a: rein pespektivisches Schemabild für ein weiteres Ausführungsbeispiel eines Niederhalters, der gleichzeitig zur Bestückung und Positionierung der Mikrochips dient,
- Fig. 4b: eine Seitenansicht des Ausführungsbeispieles gem. Fig. 4a, jedoch ohne die Z-Achsen-Verstelleinrichtung,
- Fig. 5: ein perspektivisches Schemabild eines Auführungsbeispieles für einen geteilten Niederhalter mit Format-Verstelleinrichtung,
- Fig. 6: ein perspektivisches Schemabild für den XY-Tisch des Niederhalters und die optoelektronische Lageerkennung der Chipbestückung mit Korrektur-Blockschaltbild,
- Fig. 7a: eine spezielle Ausführungsform eines Niederhalters, der gleichzeitig Träger der Anschlußelemente für die Kontaktelemente ist, in Ausgangsposition, bei Verwendung eines Mehrachsenroboters,
- Fig. 7b: die Ausführungsform gem. Fig. 7a nach Abkopplung der Anschlußelemente vom Maskenrahmen und Laser-Bestückungskopf in schematischer Darstellung, bei Verwendung eines Mehrachsenroboters,
- Fig. 7c: die Ausführungsform gern. Fig. 7a und 7b bei zusätzlicher Abwinkelungsmöglichkeit des Laser-Bestückungskopfes in zwei Richtungen.

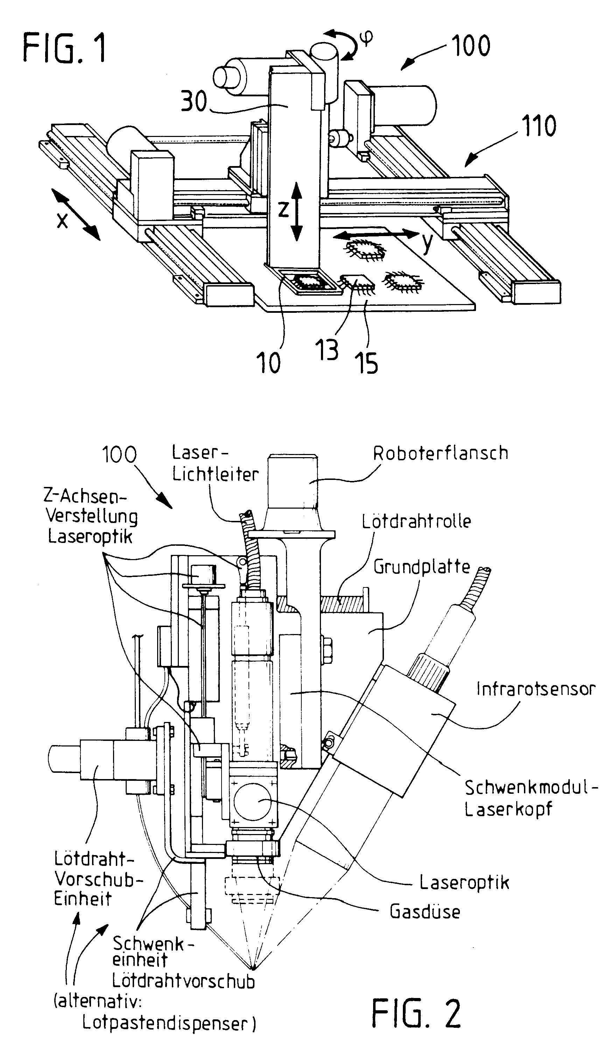

Die Fig. 1 veranschaulicht in schematischer Darstellung eine Bestückungsanlage zum Laserlöten von Feinkontakten mikroelektronischer Bauelemente, die weder mittels Flußmittel noch mit Lotpaste miteinanander verklebt werden, sondern vorbelotet sind unter Einsatz eines XY-Tisches 140, einer Z-Achsen-Verstelleinrichtung 30 und eines Laserkopfes 100, wie er in der Fig. 2 skizziert ist.

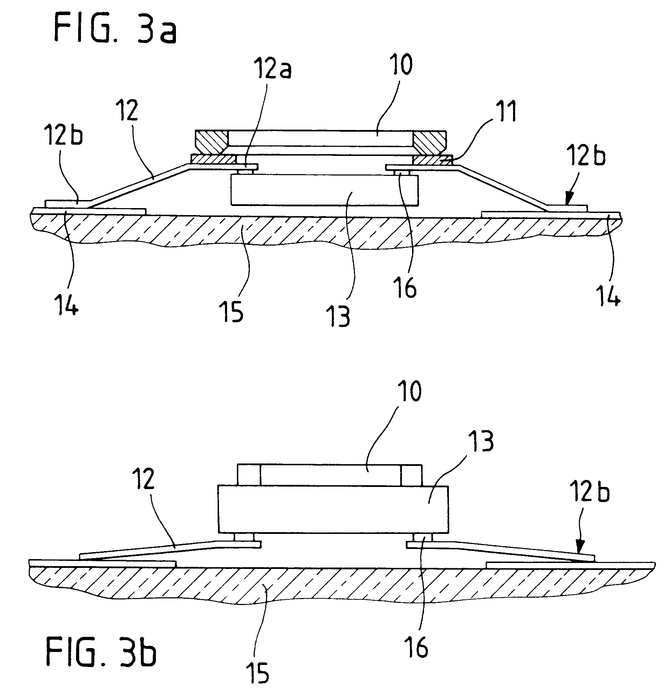

Die Fig. 3a und 3b veranschaulichen nun in schematischer Darstellung, wie vorverzinnte Mikroelektronik-Bauelemente 13 - nachstehend Chip genannt - mit zahlreichen, sehr dünnen und parallel liegenden Kontakten (Leads) 12 in sehr geringen Abständen nach dem TAB-Lötverfahren (Tape Automated Bonding) miteinander verbunden werden. Die in Fig. 1 gezeigte Z-Achsenverstelleinrichtung 30 ist mit einem rahmenförmigen Niederhalter 10 bestückt, dem gem. Fig. 3a ein sogenannter "Kapton-Rahmen" 11 zugeordnet sein kann.

Dieser Niederhalter 10 drückt nun über den Kaptonrahmen 11 oder direkt auf die Kontaktenden 12a der zahlreichen Kontaktbügel 12 des zu verlötenden Chips 13. Diese Kontaktenden 12a des Chips 13 sind nun so vorgeformt, daß durch eine definierte Druckbelastung ein mechanischer Kontakt 12b aller Kontaktbügel 12 an den Leiterbahnanschlüssen 14 erfolgt und an diesen Kontaktstellen 12b die Laserbondung erfolgt.

In der Fig. 3b ist eine Variante skizziert, bei der der Niederhalter 10 auf die Rückseite (gegenüber Fig. 3a gesehen) des Chips 13 drückt und die Kontakte 12 also auf der "Unterseite" des Chips 13 liegen. Mit 16 sind die Anschlußelemente der Kontaktbügel bezeichnet, die verschiedentlich auch als "Anschlußbeinchen" bezeichnet werden.

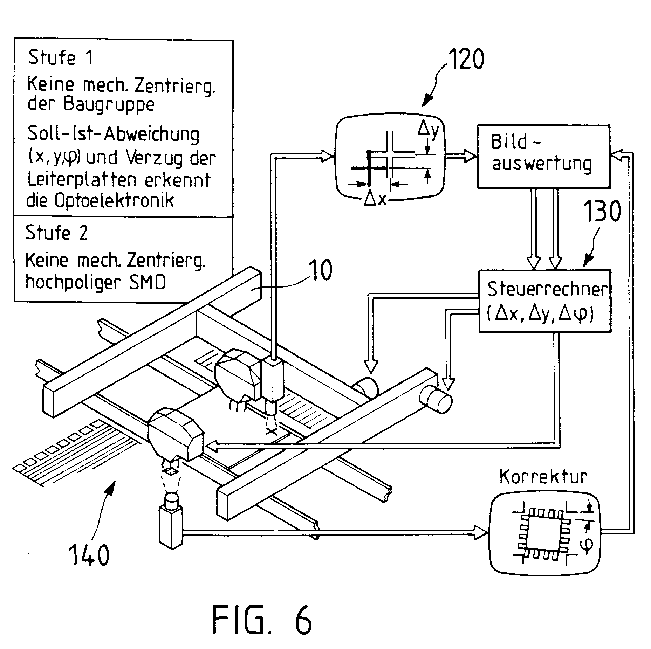

Die Funktion der in den Fig. 1 bis 3b skizierten Laserlöteinrichtung kann wie folgt beschrieben werden:
Der mit einem Visionssystem versehene Mehrachsenroboter oder XY-Tisch, deren automatische Steuerung sowie der Bestückungs- und Laserbondkopf werden aktiviert. Daraufhin erfolgt die Kalibrierung, die Grobpositionierung des Bestückungskopfes 100 über dem Bauelement (Chip) 13, die Nach- und Feinpositionierung mittels des Visionssystems (siehe Fig. 6) gemäß der vorgegebenen Bauelement-Dimensionierung.

Der Bestückungskopf 100 fährt auf den Chip 13, der mittels eines Saugrüssels 21 aufgenommen und zur Schaltungsposition - beispielsweise Leiterkarte oder Hybrid 15 - transportiert und mittels des Visionssystems positionsgenau abgesetzt wird. Die Höhenlage des Saugrüssels 21 ist verstellbar. Nach dieser Positionierung erfolgt die Entlüftung des Saugknopfes bzw. Stempels 20 und das Absetzen des rahmenförmigen Niederhalters 10.

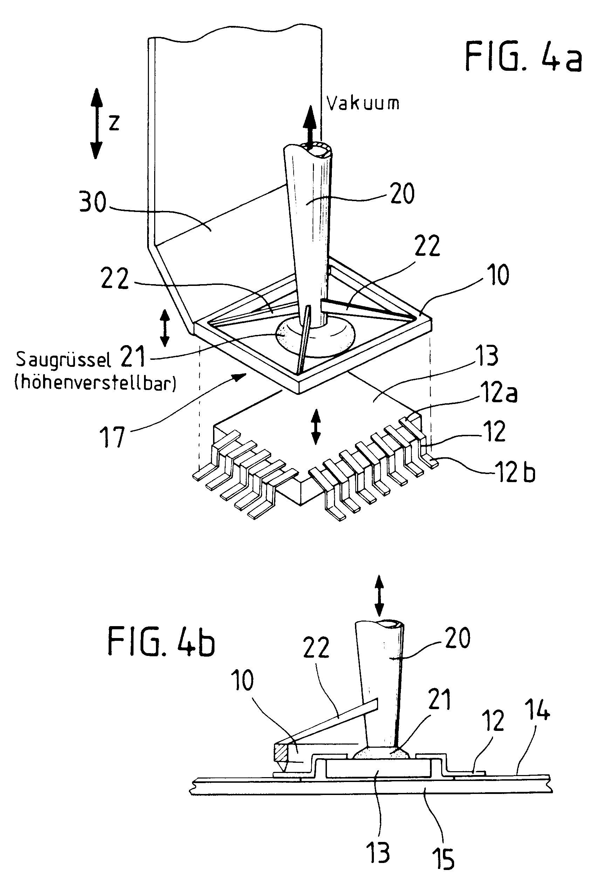

Die Fig. 4a und 4b veranschaulichen eine Ausführungsform des rahmenförmigen Niederhalters 10, der mit einem höhenverstellbaren Saugrüssel 21 an einem Stempel 20 für die gleichzeitige Bestückung und Fixierung des bzw. der Chips 13 versehen ist, wobei der rahmenförmige Niederhalter 10 mittels längenveränderlicher Rahmenhalter 22 mit dem Stempel verbunden ist.

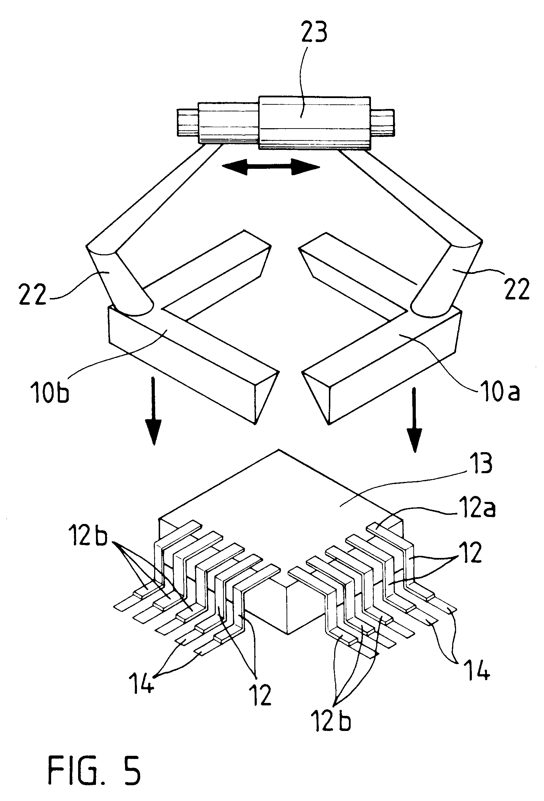

Erfindungsgemäß ist der rahmenförmige Niederhalter 10 in zwei Hälften 10a, 10b (Fig. 5) geteilt und den verschiedenen Kontaktgeometrien mittels einer Verstelleinrichtung 23 diagonal anpaßbar. Dies kann sowohl mechanisch über ein Doppelgewinde etc. aber auch pneumatisch unter Ausnützung der vorhandenen Pneumatik erfolgen, denn nach der Positionierung des Chips und Entlüftung des Saugknopfes 20 wird der Bestückungskopf 100 pneumatisch abgekoppelt und in die Nullposition bzw. die Laserposition gebracht.

Zum rahmenförmigen Niederhalter 10 ist noch anzuführen, daß er über einen ihm zugeordneten XY-Tisch 140 (Fig. 6) und ein Bilderkennungssystem 120 sowie einem Korrektursteuersystem 130 zur exakten Position gebracht wird. Um Laserstrahlabschattungen zu vermeiden, ist der Niederhalter 10 sehr flach konzipiert. Vorteilhaft wirkt sich auch eine unterseitige rasterförmige Teflon-Isolationsschicht 17 aus.

Der rahmenförmige Niederhalter 10 wird also vor und nach dem Löten pneumatisch in Z-Richtung hochgefahren, unmittelbar vor und während des Lötvorganges leicht und definiert an die Kontaktenden 12a bzw. 12b angedrückt. In Z-Richtung wird lediglich bis auf einen konstanten Federdruck jedoch nicht maßgesteuert der Niederhalter 100, ausgefahren. Der zu seiner Einstellung angeordnete XY-Tisch 140 wird von der gleichen Steuerung versorgt, die dem XY-Tisch des Laserkopfes 100 zugeordnet ist. Dies gilt selbstverständlich nur für Anlagen mit solchen Tischen.

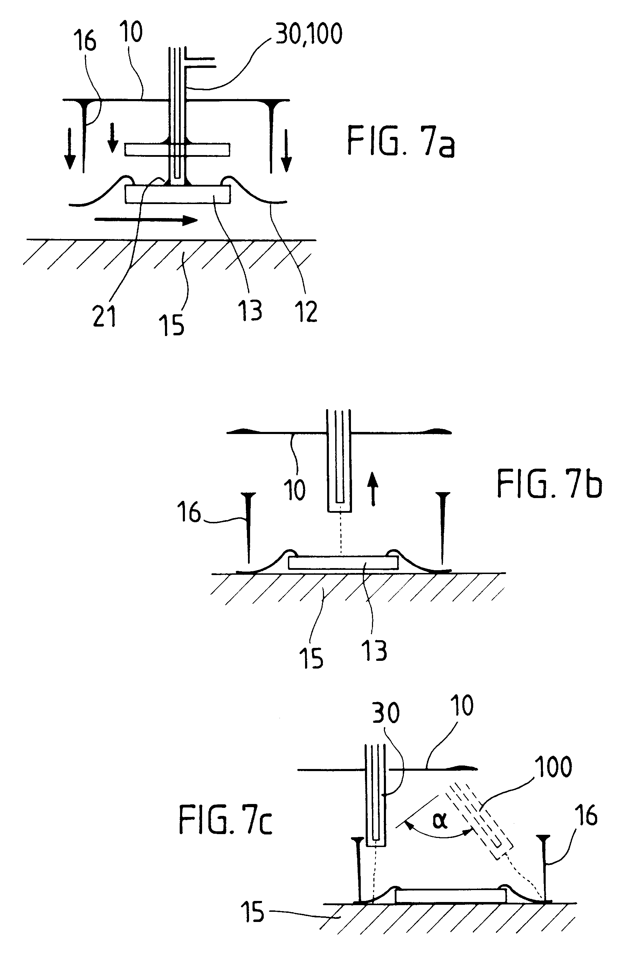

Die Fig. 7a bis 7c veranschaulichen eine Variante zur wirtshaftlichen Laserbondung mit einem Mehrachsenroboter, also ohne XY-Tisch 110. Auch hier wird der Mehrachsenroboter mit Visionssystem, die automatische Steuerung und der Bestückungs- und Laserbondkopf 100, aktiviert, wodurch die Kalibrierung, Grobpositionierung des Bestückungskopfes über dem Bauelement 13, die Nach- und Feinpositionierung mittels des Visionssystems erfolgt.

Der Laser- und Bestückungskopf 100 arbeitet prinzipiell gleich, lediglich die "Anschlußbeinchen" 16 werden nicht innen am Bauelement (Chip) 13, sondern an den äußeren Enden der Kontaktbügel 12 vor dem Niederhalter 10 angedrückt. Hierei erfolgt die Abkopplung vom Niederhalter 10 und Laser-Bestückungskopf 100 elektromagnetisch.

Der abgekoppelte Laser-Bestückungskopf 100 fährt dann nach CIM-Programm (CIM=Computer Integrated Manufacturing = rechnergesteuerte Fertigung) die Positionen der Kontaktanschlüsse 12 ab und verlötet zunächst in der Mitte zur Verklebung des Bauelementes 13 und dann die einzelnen Anschlüsse. Als vorteilhaft erweist sich die Maßnahme, den Laser-Bestückungskopf 100 beim Mehrachsenroboter zusätzlich abwinkelbar auszubilden bzw. zu lagern und zwar so, daß er in einem bestimmten Winkel α in zwei Richtungen auslenkbar ist.

Durch die vorbeschriebenen Ausführungsformen ist nun die Möglichkeit geschaffen, vorverzinnte, flußmittel-, pasten- oder kleberfreie Mikrokontakte mittels eines speziellen rahmenförmigen Niederhalters geometrisch so einwandrei fixiert werden, daß eine optimale Lötverbindung ermöglicht wird.

## Patentansprüche

1. Einrichtung zum Laserlöten von Feinkontakten vorbeloteter mikroelektronischer Bauelemente (13) mittels eines Laserbestückungskopfes (100), der mit einer Verstelleinrichtung (30) längs der Z-Achse höhenverstellbar ist und von einem Mehrachsenroboter oder XY-Tisch (110) programm- und rechnergesteuert getragen und geführt wird und einen rahmenförmigen Niederhalter (10) versehen ist, der das zu verlötende TAB-Bauelement (Tape Automated Bonding-Chip) (13) mit definiertem Druck belastet, **dadurch gekennzeichnet, daß** der rahmenförmige Niederhalter (10) in zwei Hälften (10a, 10b) geteilt und den verschiedenen Kontaktgeometrien mittels einer Verstelleinrichtung (23) anpaßbar ist, wobei von dem Niederhalter (10) die Anschlußelemente (16) zwischen TAB-Bauelement (13) und Kontaktbügel (12) an deren äußeren Enden an das Substrat (Kleberfilm) (15) angedrückt werden.

2. Einrichtung nach Anspruch 1, **dadurch gekennzeichnet, daß** der rahmenförmige Niederhalter (10) mittels längenveränderlicher Rahmenhalter (22) an dem Stempel (20) oder dem Saugrüssel (21) verbunden ist.

3. Einrichtung nach Anspruch 1 oder 2, **dadurch gekennzeichnet, daß** der rahmenförmige Niederhalter (10) in seinen Dimensionen flach ausgebildet ist und an seiner Unterseite mit einer Teflonschicht (17) rasterförmig isoliert ist

4. Einrichtung nach einem der Ansprüche 1 bis 3, **dadurch gekennzeichnet, daß** dem rahmenförmigen Niederhalter (10) zur exakten Positionierung ein XY-Tisch (140), ein Bilderkennungssystem (120) und ein Korrektursystem (130) zugeordnet ist.

5. Einrichtung nach einem der Ansprüche 1 bis 4, **dadurchgekennzeichnet,daß** der XY-Tisch (140) des rahmenförmigen Niederhalter (10) von der gleichen Steuereinrichtung gefahren wird, wie der darüber angeordnete XY-Tisch (110) des Laserkopfes (100).

6. Einrichtung nach einem der Ansprüche 1 bis 5, **dadurch gekennzeichnet, daß** zur Abkopplung der Anschlußelemente (16) der Kontaktbügel (12) vom rahmenförmigen Niederhalter (10) und Laser-Bestückungskopf (100) eine elektromagnetische Einrichtung erfolgt.

## Claims

1. Device for laser-soldering of fine contacts of pre-soldered micro-electronic assembly components (13) by means of a laser tipping head (100), which is height-adjustable along the Z-axis by means of an adjusting device (30) and which is supported and guided by way of program- or computer-control of a multi-axes robot or an XY-table (110) and which is provided with a frame-like hold-down device (10) which loads the TAB assembly component (Tape Automated Bonding-Chip)(13) with a defined pressure, **characterised in that** the frame-shaped hold-down device (10) is divided into two halves (10a, 10b) and adaptable to the different contact geometries by means of an adjusting device (23), in which respect the connecting elements (16) between the TAB assembly component (13) and the contact yokes (12) are pressed by the hold-down device (10) at their outer ends against the substrate (adhesive film) (15).

2. Device according to claim 1, **characterised in that** the frame-shaped hold-down device (10) is connected to the stamp (20) or the suction tube (21) by means of frame holders (22) which are of adjustable length.

3. Device according to claim 1 or 2, **characterised in that** the frame-shaped hoiding-down device (10) is of a dimensionally flat structure and at its lower side raster-like insulated by a teflon coating (17).

4. Device according to one of claims 1 to 3, **characterised in that**, for the purpose of precise positioning, the frame-shaped holding-down device (10) is associated with an XY-table (140, an image detection system (120) and a correcting system (130).

5. Device according to one of claims 1 to 4, **characterised in that** the XY-table (140) of the frame-shaped hold-down device (10) is driven by the same control device as the XY-table (110) of the laser head (100) which is positioned there-above.

6. Device according to one of claims 1 to 5, **characterised in that** an electromagnetic device serves the disconnection of the connecting elements (16) of the contact yokes (12) from the frame-shaped hold-down device (10) and the laser tipping head (100).

## Revendications

1. Dispositif pour le soudage par laser de contacts fins de composants (13) de micro-électronique pré-enrobés de métal d'apport au moyen d'une tête de montage de composants à laser (100) qui peut être déplacée en hauteur le long de l'axe Z au moyen d'un dispositif de positionnement (30), est supportée et guidée avec commande par programme ou par ordinateur par un robot multiaxe ou une table XY (110) et est pourvue d'un dispositif presseur (10) en forme de cadre qui exerce une pression déterminée sur le composant TAB (Tape Automated Bonding Chip) (13) à souder, caractérisé par le fait que le dispositif presseur (10) en forme de cadre est divisé en deux parties (10a, 10b) et peut être adapté aux diiférentes formes de contacts grâce à un dispositif de réglage (23), le dispositif presseur (10) pressant les éléments de connexion (16) entre le composant TAB (13) et les pattes de contact (12) au niveau de leurs extrémités sur le substrat (film d'adhésif) 15.

2. Dispositif selon la revendication 1, caractérisé par le fait que le dispositif presseur (10) en forme de cave est lié à la tige (20) ou à la buse d'aspiration (21) par l'intermédiaire d'un porte cadre (22) réglable en longueur.

3. Dispositif selon la revendication 1 ou 2, caractérisé par le fait que le dispositif presseur (10) en forme de cadre est plat et que sa face inférieure est isolée au moyen d'une couche de téflon (17) agencée en réseau .

4. Dispositif selon l'une des revendications 1 à 3, caractérisé par le fait qu'aux fins d'assurer un positionnement précis, une table XY (140), un système de prise de vue (120) et un système de correction (130) sont associés au dispositif Presseur (10) en forme de cadre.

5. Dispositif selon l'une des revendications 1 à 4, caractérisé par le fait que la table XY (140) du dispositif presseur (10) en forme de cadre est dépIacée par le même dispositif de commande que la table XY (110) disposée au-dessus de la tête à laser (100).

6. Dispositif selon l'une des revendications 1 à 5, caractérisé par le fait que la séparation des éléments de connexion (16) des pattes de contact (12) du dispositif presseur (10) en forme de cadre et de la tête à laser (100) est opérée au moyen d'un dispositif électro-magnétique.
